# EUROPÄISCHE PATENTSCHRIFT

(11) **EP 0 831 676 B1**
(45) Veröffentlichungstag und Bekanntmachung des Hinweises auf die Patenterteilung: **07.01.2004**
(21) Anmeldenummer: 97202820.3
(22) Anmeldetag: 15.09.1997
(51) Int. Cl.: H05B 33/14, C09K 11/06

(54) **Organisches Elektrolumineszentes Bauelement mit Exciplex**
Organic electroluminescent element with exciplex
Elément électroluminescent organique avec exciplex

(30) Priorität: 21.09.1996 DE 19638770
(43) Veröffentlichungstag der Anmeldung: 25.03.1998
(73) Patentinhaber: Philips Intellectual Property & Standards GmbH, 20099 Hamburg (DE); Koninklijke Philips Electronics N.V., 5621 BA Eindhoven (NL)
(72) Erfinder: Boerner, Herbert, Dr., Röntgenstrasse 24, 22335 Hamburg (DE); Busselt, Wolfgang, Röntgenstrasse 24, 22335 Hamburg (DE); Jüstel, Thomas, Dr., Röntgenstrasse 24, 22335 Hamburg (DE); Nikol, Hans, Dr., Röntgenstrasse 24, 22335 Hamburg (DE)
(74) Vertreter: Volmer, Georg, Dipl.-Ing.

(56) Entgegenhaltungen:
- EP-A- 0 704 436
- EP-A- 0 712 916
- US-A- 5 420 288
- PATENT ABSTRACTS OF JAPAN vol. 095, no. 006, 31.Juli 1995 & JP 07 085972 A (TOSHIBA CORP), 31.März 1995,
- LIN, CHING-PIAO ET AL: "Electroluminescence of molecularly-doped polymer films using coumarin derivative as an emissive center" J. POLYM. RES. (1995), 2(3), 133-8 CODEN: JPOREP;ISSN: 1022-9760, 1995, XP002064787
- YAMAMOTO T ET AL: "Polymer light-emitting diodes with single- and double-layer structures using poly(2,3-diphenylquinoxaline-5,8-diyl)" JAPANESE JOURNAL OF APPLIED PHYSICS, PART 2 (LETTERS), 15 FEB. 1994, JAPAN, Bd. 33, Nr. 2B, ISSN 0021-4922, Seiten L250-L253, XP002064788
- CHIHAYA ADACHI ET AL: "BLUE LIGHT-EMITTING ORGANIC ELECTROLUMINESCENT DEVICES" APPLIED PHYSICS LETTERS, Bd. 56, Nr. 9, 26.Februar 1990, Seiten 799-801, XP000126760
- PATENT ABSTRACTS OF JAPAN vol. 095, no. 011, 26.Dezember 1995 & JP 07 220873 A (SUMITOMO ELECTRIC IND LTD), 18.August 1995,

## Beschreibung

Die Erfindung betrifft ein organisches elektrolumineszentes Bauelement mit einem transparenten Substrat, einer ersten transparenten Elektrode, einer organischen elektrolumineszenten Schicht und einer zweiten Elektrode.

Elektrolumineszente Bauelemente, die aus organischen Schichten aufgebaut sind, sind von großem Interesse, weil sie sich als großflächige Displays herstellen lassen, die mit niedriger Spannung betrieben werden können, eine kurze Ansprechzeit und ein geringes Gewicht haben. Sie können auch in Form biegsamer Folien hergestellt werden, die flexibler einsetzbar sind als herkömmliche elektrolumineszente Bauelemente aus anorganischem Halbleitermaterial. Einsatzgebiete für organische elektrolumineszente Bauelemente sind daher Displays aller Art, insbesondere auch flache Monitore und Farbbildschirme. Wegen ihres geringen Gewichtes eignen sich die Bauelemente als Lichtquellen in Flugzeugen und Raumschiffen. Es besteht weiterhin die Möglichkeit, daß diese Bauelemente als Laserdiode eingesetzt werden.

Herkömmliche organische elektrolumineszente Bauelemente haben im allgemeinen einen Schichtaufbau aus mehreren getrennten Schichten. Beispielsweise ist aus der US 4,720,432 ein organisches elektrolumineszentes Bauelement bekannt, das aufeinanderfolgend eine Anode, eine organische löcherinjizierende und -transportierende Zone, eine organische elektroneninjizierende und -transportierende Zone und eine Kathode umfaßt und dadurch gekennzeichnet ist, daß die löcherinjizierende und -transportierende Zone eine Schicht umfaßt, die in Kontakt mit der Anode steht und eine löcherinjizierende Porphyrin-Verbindung enthält, und weiterhin eine Schicht umfaßt, die ein löchertransportierendes tertiäres aromatisches Amin enthält und zwischen der löcherinjizierenden Schicht und der elektroneninjizierenden und -transportierenden Zone liegt.

Aus PATENT ABSTRACTS OF JAPAN vol. 095, no. 006, 31.Juli 1995 & 085972 A (TOSHIBA CORP), 31.März 1995; LIN, CHING-PIAO ET AL: 'Electroluminescence of molecularly-doped polymer films using coumarin derivative as an emissive center' J. POLYM. RES. (1995), 2(3), 133-8 CODEN: JPOREP;ISSN: 1022-9760, 1995, XPO02064787 und YAMAMOTO T ET AL: 'Polymer light-emitting diodes with singleand double-layer structures using poly(2,3-diphenylquinoxaline-5,8-diyl)' JAPANESE JOURNAL OF APPLIED PHYSICS, PART 2 (LETTERS), 15 FEB. 1994, JAPAN, Bd. 33, Nr. 213, ISSN 0021-4922, Seiten L250-L253, XPO02064788 ist der Aufbau eines organischen elektrolumineszenten Bauelements mit einem transparentes Substrat, gefolgt von einer transparenten Elektrode, gefolgt von einer organischen elektrolumineszenten Schicht, die aus einer Mischschicht von löchertransportierendem und von elektronentransportierendem organischen Material besteht und einen Exciplex bildet, gefolgt von einer zweiten Elektrode bekannt.

Anordnungen für ein organisches elektrolumineszentes Bauelement beschreibt auch US-A-5 420 288 (OHTA MASAFUMI ET AL).

Aus dem Stand der Technik gemäß PATENT ABSTRACTS OF JAPAN vol. 095, no. 006, 31.Juli 1995 & 085972 A (TOSHIBA CORP), 31.März 1995 und PATENT ABSTRACTS OF JAPAN vol. 095, no. 011, 26.Dezember JP 07 220873 A (SUMITOMO ELECTRIC IND LTD), 18.August 1995, sind weiterhin verschiedene elektronen- und löchertransportierende Materialien bekannt.

Derartig vielfältige getrennte Kombinationen von Schichten aus ladungsinjizierenden und ladungstransportierenden organischen Materialien haben zwangsläufig viele Grenzflächen. Die Übergangsspannungen an den Grenzflächen führen zu einer unerwünschten Erhöhung der Einsatzspannung, zu einer Erniedrigung der Strom dichte und einer Verminderung der Lichtintensität in dem elektrolumineszenten Bauelement.

Es ist daher eine Aufgabe der vorliegenden Erfindung, ein organisches elektrolumineszentes Bauelement mit einem einfachen Schichtaufbau zur Verfügung zu stellen.

Erfindungsgemäß wird die Aufgabe gelöst durch ein organisches elektrolumineszentes Bauelement mit einem transparenten Substrat, einer ersten transparenten Elektrode, einer organischen elektrolumineszenten Schicht, die eine Mischschicht aus einem Gemisch eines löchertransportierenden und eines elektronentransportierenden organischen Materials, das einen Exciplex bildet, ist und einer zweiten Elektrode, wobei zwischen der ersten Elektrode und der Mischschicht eine Schicht aus einem löchertransportierenden organischen Material und/oder zwischen der zweiten Elektrode und der Mischschicht eine Schicht aus einem elektronentransportierenden organischen Material angeordnet ist.

Für die Mischschicht werden Kombinationen eines löchertransportierenden Materials und eines elektronentransportierenden Material ausgewählt, die einen lichtemittieren den Exciplex bilden. Erfindungsgemäß wird auf die Verwendung von zusätzlichen Emittersubstanzen verzichtet. Dadurch wird ein einfacher Schichtaufbau für das organische elektrolumineszente Bauelement erreicht, das sich durch verbesserte Betriebseigenschaften, insbesondere durch niedrige Einsatzspannung und hohe Luminanz bei kleiner Spannung auszeichnet. Weil außer den löchertransportierenden und den elektronentransportierenden Verbindungen, bei denen die dem Ladungstransport dienenden Redoxprozesse reversibel sind, keine weiteren Substanzen verwendet werden, haben die Bauelemente eine lange Lebensdauer. Die Bauelemente zeigen keine Selbstabsorption und keine Absorption im sichtbaren Spektralbereich.

Bei der Anordnung der Mischschicht zwischen reinen löchertransportierenden und/oder elektronentransportierenden Substanzen ist der strahlungslose Abfluß der Ladungsträger über die Elektroden behindert. Es wird eine verbesserte Rekombination der Ladungsträger und eine höhere Lichtausbeute erzielt.

Im Rahmen der vorliegenden Erfindung ist es bevorzugt, daß das Gemisch, das einen Exciplex bildet, als löchertransportierende Material eine oder mehrere Verbindungen aus der Gruppe 4,4',4"-tris(3-Methylphenylphenyl-amino)-triphenyl amin (MTDATA), N,N'-Diphenyl-N,N'-bis(3-methylphenyl)-1,1'-biphenyl-4,4'diamin (TPD), N,N'- di(4-Methyl-phenyl)-N,N'-diphenyl-1,4-phenylendiamin und 1,1'-bis-(4'-bis-(4'-methyl-phenyl)-amino-phenyl)-cyclohexan (TAPC) und als elektronentransportierende Material eine oder mehrere Verbindungen aus der Gruppe 2-(4-Biphenylyl)-5-(tert.-butylphenyl)-1,3,4-oxadiazol (butyl-PBD), 2-(4-Biphenylyl)-5-phenyl-1,3,4-oxadiazol (PBD) und 5-(4-Biphenylyl)-3-(tert.butylphenyl)-1,2,4-triazol (TAZ) enthält.

Diese Verbindungen bilden paarweise Exciplexe, d.h. durch Wechselwirkung der beiden Verbindungen in einem Addukt entstehen elektronisch angeregte Komplexe, die im Grundzustand dissoziiert sind, aber im angeregten Zustand eine schwache chemische Bindung aufweisen. Durch die Exciplexbildung verändert sich das Emissionsspektrum. Die Emissionslinien der separaten Verbindungen verschwinden und man erhält eine breite, charakteristische Emission, die im Vergleich zu den Einzelkomponenten in den niederfrequenten Bereich verschoben ist.

Es ist im Rahmen der vorliegenden Erfindung besonders bevorzugt, daß das löchertransportierende Material 4,4',4"-tris(3-Methylphenylphenylamino)-triphenylamin (MTDATA) und das elektronentransportierende Material 5-(4-Biphenylyl)-3-(tert.butylphenyl)-1,2,4-triazol (TAZ) ist.

Nachfolgend wird die Erfindung anhand von sechs Figuren weiter erläutert.
- **Fig. 1**: zeigt eine Ausführungsform nach dem Stand der Technik mit einer einfachen Mischschicht.
- **Fig. 2**: zeigt eine Ausführungsform der Erfindung mit einer Mischschicht und einer elektronentransportierenden Schicht.
- **Fig. 3**: zeigt eine Ausführungsform der Erfindung mit einer Mischschicht, einer elektronentransportierenden Schicht und einer löchertransportierenden Schicht.
- **Fig. 4**: zeigt die Strom - Spannungskennlinie des Ausführungsbeispieles 1.
- **Fig. 5**: zeigt die Strom-Luminanz-Kurve des Ausführungsbeispieles 1 und
- **Fig. 6**: das Emissionsspektrum des Ausfühhrungsbeispieles 1.
- **Fig. 7**: zeigt die Strom - Spannungskennlinie des Ausführungsbeispieles 2.
- **Fig. 8**: zeigt die Strom-Luminanz-Kurve des Ausführungsbeispieles 2 und
- **Fig. 9**: das Emissionsspektrum des Ausführungsbeispieles 2.
- **Fig. 10**: zeigt das Absorptionsspektrum eines Exciplexes im Vergleich zu den Absorptionsspektren der Ausgangsverbindungen.

Ein organisches elektrolumineszierendes Bauelement nach dem Stand der Technik besteht in seiner einfachsten Ausführungsform aus einer Substratschicht **1,** einer ersten, transparenten Elektrodenschicht **2,** einer Mischschicht **3** sowie einer zweiten Elektrode **4.**

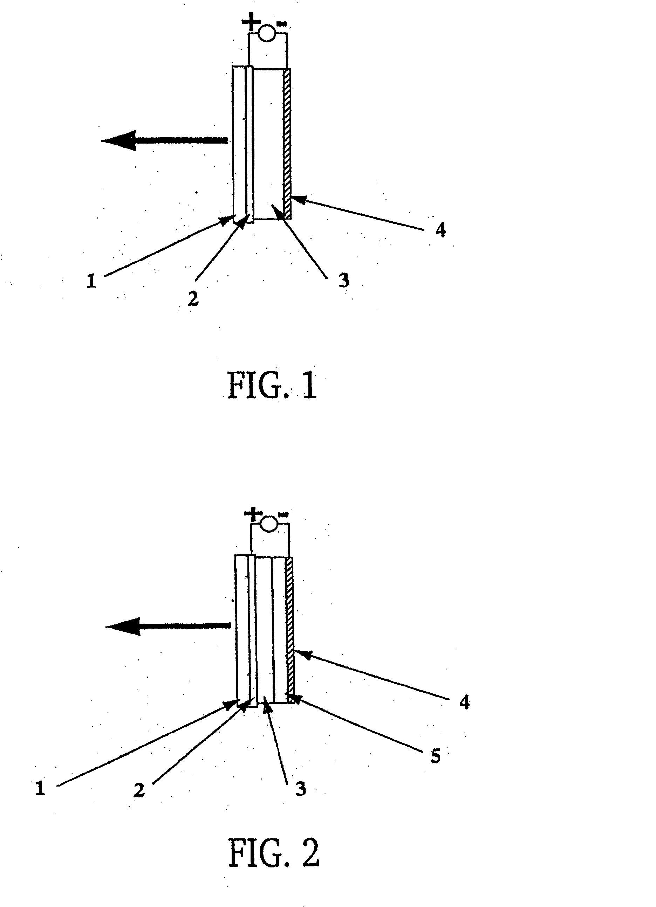

In einer ersten Ausführungsform der Erfindung gemäß **Fig. 2** ist zwischen der Mischschicht **3** und der zweiten Elektrode **4** eine elektronentransportierende Schicht **5** angeordnet.

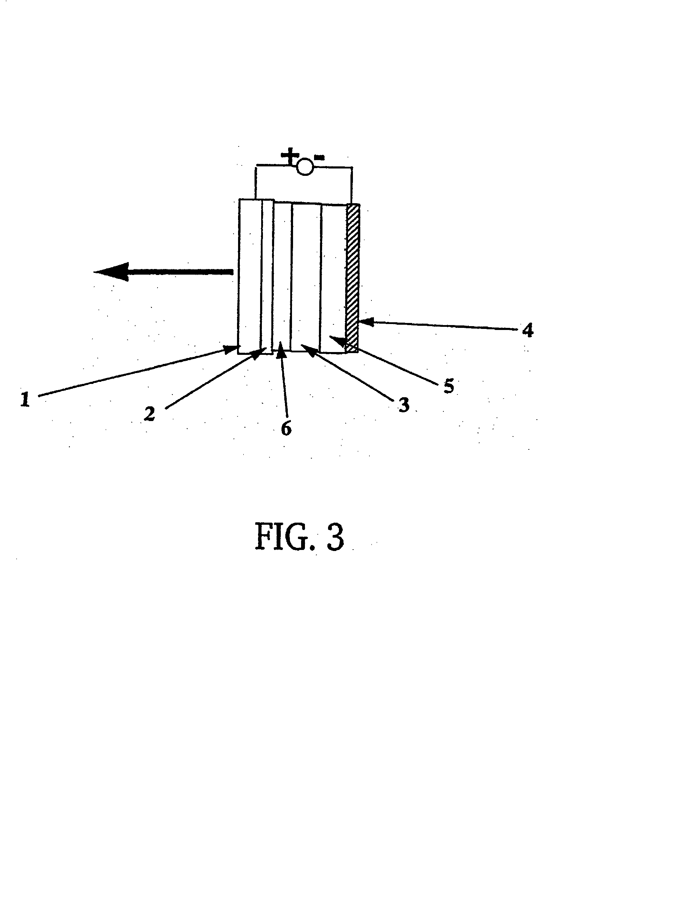

Eine weitere Ausführungsform gemäß **Fig. 3** umfaßt drei separate optoelektronisch funktionelle Schichten - eine löchertransportierende Schicht **6,** eine Mischschicht **3** und eine elektronentransportierende Schicht **5.**

Als Substrat **1** dient immer eine Platte aus einem lichtdurchlässigen Material, bei spielsweise eine Glasplatte. Darauf ist als dünner Film von einigen 100 nm Dicke die Anode **2** aufgebracht, die ebenfalls lichtdurchlässig sein muß. Darauf folgen gegebenenfalls die löchertransportierende Schicht mit einer Schichtdicke von 100 nm bis 2000 nm, bevorzugt 500 nm, die Mischschicht mit einer Schichtdicke von 100 nm bis 2000 nm, bevorzugt 200 nm und gegebenenfalls die elektronentransportieren de Schicht mit einer Schichtdicke von 100 nm bis 2000 nm, bevorzugt 500 nm.

Vervollständigt wird das organische, elektrolumineszente Bauelement durch die Kathode **4**.

Als Material für die transparente Anode, von der aus Löcher in die p-leitende Schicht injiziert werden, sind Metalle, Metalloxide oder elektrisch leitende organische Polymere mit hoher Austrittsarbeit für Elektronen geeignet. Beispiele sind dünne, transparente Schichten aus indiumdotiertem Zinnoxid (ITO), Gold oder Polyanilin.

Für die Mischschicht werden Kombinationen von elektronentransportierenden und elektronentransportierenden Verbindungen, die Exciplexe bilden, verwendet. Dies sind beispielsweise Kombinationen von 4,4',4"-tris(3-Methylphenylphenylamino)triphenylamin (MTDATA) oder N,N'- di(4-Methyl-phenyl)-N,N'-diphenyl-1,4-phenylendiamin (DPPD) mit 2-(4-Biphenylyl)-5-(tert.-butylphenyl)-1,3,4-oxadiazol (butyl-PBD), 2-(4-Biphenylyl)-5-phenyl-1,3,4-oxadiazol (PBD) oder 5-(4-Biphenylyl)-3-(tert.-butylphenyl)-1,2,4-triazol (TAZ). Bevorzugt ist die Kombination von MTDATA mit PBD oder butyl-PBD.

Für die löcherleitende Schicht, die in Kontakt mit der Anode und der Mischschicht steht, werden bevorzugt leitende Triphenylaminderivate wie 4,4',4"-tris(3-Methylphenylphenylamino)triphenylamin (MTDATA), N,N'-Diphenyl-N,N'-bis(3-methylphenyl)-1,1'-biphenyl-4,4'-diamin (TPD), N,N'-di(4-Methyl-phenyl)-N,N'diphenyl-1,4-phenylendiamin (DPPD) oder 1,1'-bis-(4'-bis-(4'-methyl-phenyl)-amino-phenyl)-cyclohexan (TAPC) verwendet.

Für die elektronentransportierende Schicht, die in Kontakt mit der Kathode und der Mischschicht steht, werden bevorzugt 2-(4-Biphenylyl)-5-(tert.-butylphenyl)-1,3,4-oxadiazol (butyl-PBD), 2-(4-Biphenylyl)-5-phenyl-1,3,4-oxadiazol (PBD) oder 5-(4-Biphenylyl)-3-(tert.-butylphenyl)-1,2,4-triazol (TAZ) verwendet.

Als Werkstoff für die Kathode werden Metalle mit niedriger Austrittsarbeit eingesetzt, da von der Kathode her Elektronen in die elektronentransportierende Schicht injiziert werden müssen. Solche Metalle sind Aluminium, Magnesium und Legierungen von Magnesium mit Silber oder Indium sowie Calcium, Alkalimetalle wie Li, Na, K, Cs, oder Seltenerdmetallen wie Europium oder Terbium.

Zur Herstellung der Mischschicht können die elektronentransportierenden oder löchertransportierenden Materialien aus Lösung aufgebracht, im Hochvakuum aufgedampft, sublimiert oder in situ polymerisiert werden. Die löchertransportierenden und die elektronentransportierenden Verbindungen werden gemeinsam abgeschieden, so daß eine homogene Mischung in der Mischschicht entsteht.

Im Betrieb wird eine Gleichstromspannung an die beiden Elektroden angelegt. Dabei liegt die erste Elektrode auf positivem Potential (Anode), die zweite auf negativem Potential (Kathode). Wenn die über die Mischschicht abfallende Spannung einen Schwellenwert überschritten hat werden von der Anode positive Ladungsträger, also Löcher, in das den Exciplex bildende Material injiziert. Von der Kathode werden negative Ladungsträger, also Elektronen, injiziert. Sie rekombinieren in der Mischschicht und liefern dabei die Anregungsenergie für den Exciplex. Die Anregungsenergie wird in Form von Strahlung wieder abgegeben. Die erfindungsgemäß verwendeten löcher- bzw. elektronentransportierenden Verbindungen emittieren als einzelne Substanzen im ultravioletten oder blauen Spektralbereich, in der einen Exciplex bildenden Kombination jedoch im grünen oder gelben Bereich. Besonders die Kombination von MTDATA und PBD oder butyl-PBD zeigen eine sehr ausgeprägte grüne Exciplex-Emission.

Zur Charakterisierung der Bauelemente werden Versuchsproben mit einer emittierenden Fläche von 0,5 cm Durchmesser hergestellt und daran die Strom-Spannungskurve, die Strom-Luminanz-Kurve und das Emissionsspektrum gemessen.

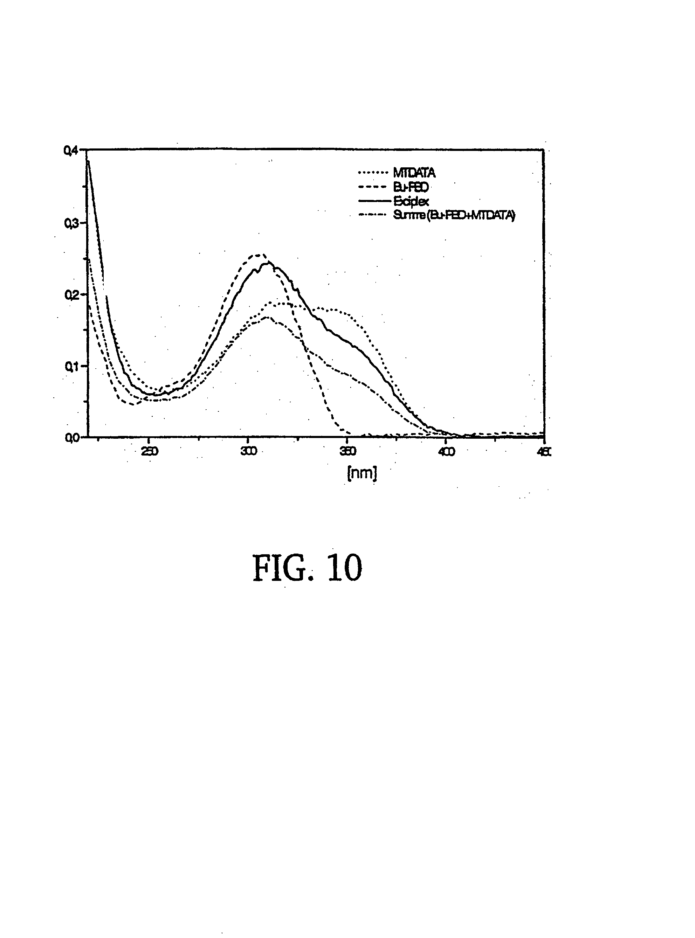

Für die Messung des Absorptionsspektrums werden auf Quarzglas als Substrat Lösungen der erfindungsgemäßen Kombination MTDATA mit butyl-PBD sowie die Lösungen der beiden Ausgangsverbindungen in Polymethacrylsäuremethylester durch ein Spin-Coating-Verfahren aufgebracht. Fig. 10 zeigt die Absorptionsspektren der einzelnen Komponenten MTDATA und Butyl-PBD, das durch mathematische Addition erzeugte Summenspektrum von MTDATA und butyl-PBD und das Spektrum der Kombination von MDATA und butyl-PBD. Das Summenspektum und das Spektrum der Kombination sind identisch. Das macht in Verbindung mit den Emissionsspektren deutlich, daß eine echte Exciplexbildung und kein Charge-Transfer-Komplex vorliegt. Sowohl die Emission als auch die Absorption ist in relativen Einheiten angegeben.

### Ausführungsbeispiel 1

Eine mit indiumdotiertem Zinnoxid beschichtete Glasplatte wird zur Reinigung mit einer KOH/Äthanol-Lösung und anschließend mit deionisiertem Wasser und Äthanol gespült. Sie wird getrocknet und 15 min im UV-Ozonisator behandelt. Anschließend werden folgende Schichten im Hochvakuum bei 5 x 10⁻⁶ mbar aufgedampft: als löchertransportierende Schicht MTDATA, Schichtdicke 250 nm, als Mischschicht MTDATA und TAZ im molaren Verhältnis 1:1 , Schichtdicke 600 nm, als elektronentransportierende Schicht TAZ, Schichtdicke 280 nm, als Kathode Ca, Schichtdicke 250 nm, und Al, Schichtdicke 880 nm.

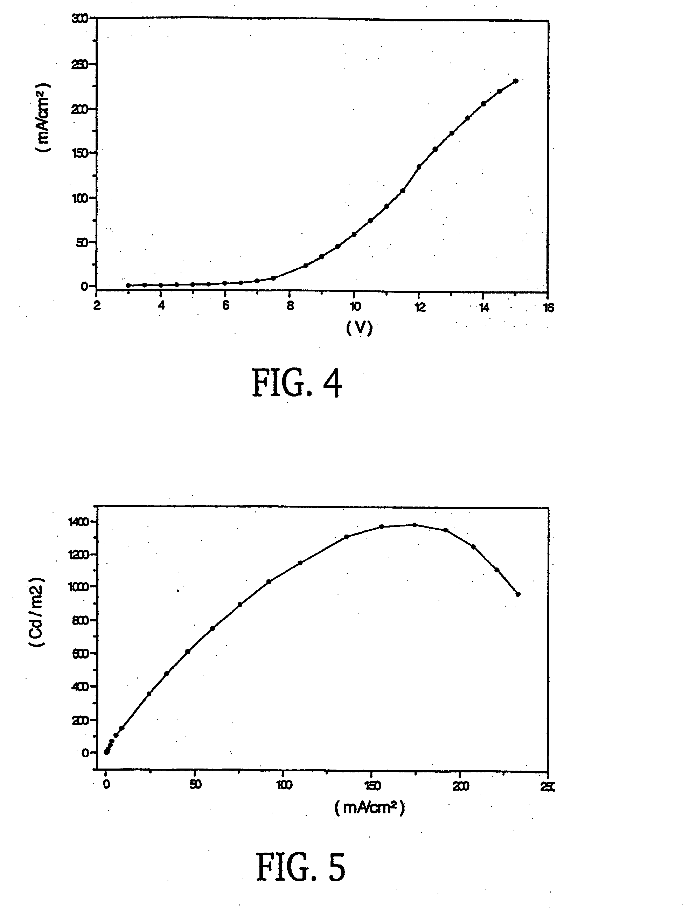

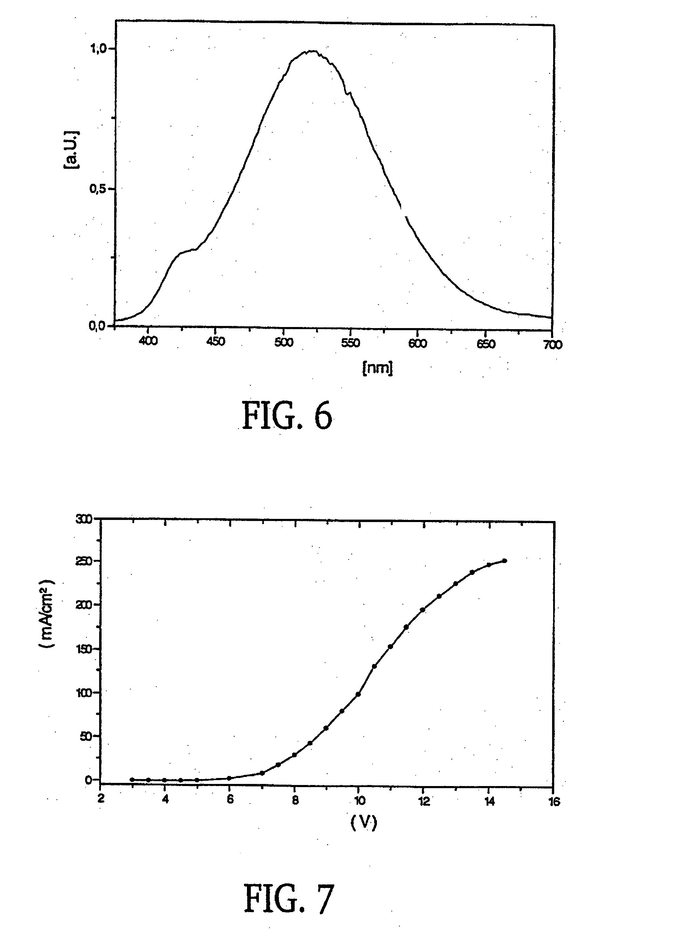

Bei Anlegen einer Spannung von 10 Volt wird eine Luminanz von 700 cd/m² bei einem Strom von 50 mA/cm² beobachtet. Die Strom - Spannungskennlinie ist in Fig. 4, die Strom-Helligkeitskurve in Fig. 5 und das Emissionsspektrum in Fig. 6 abgebildet.

### Ausführungsbeispiel 2

Eine mit indiumdotiertem Zinnoxid beschichtete Glasplatte wird wie in Ausführungsbeispiel 1 beschrieben gereinigt und vorbehandelt. Anschließend werden folgende Schichten im Hochvakuum bei 5 x 10⁻⁶ mbar aufgedampft: als löchertransportierende Schicht MTDATA, Schichtdicke 200 nm, als Mischschicht MTDATA und bu-PBD im molaren Verhältnis 3:1 , Schichtdicke 513 nm, als elektronentransportierende Schicht TAZ, Schichtdicke 290 nm, als Kathode Ca, Schichtdicke 250 nm, und Al, Schichtdicke 2000 nm.

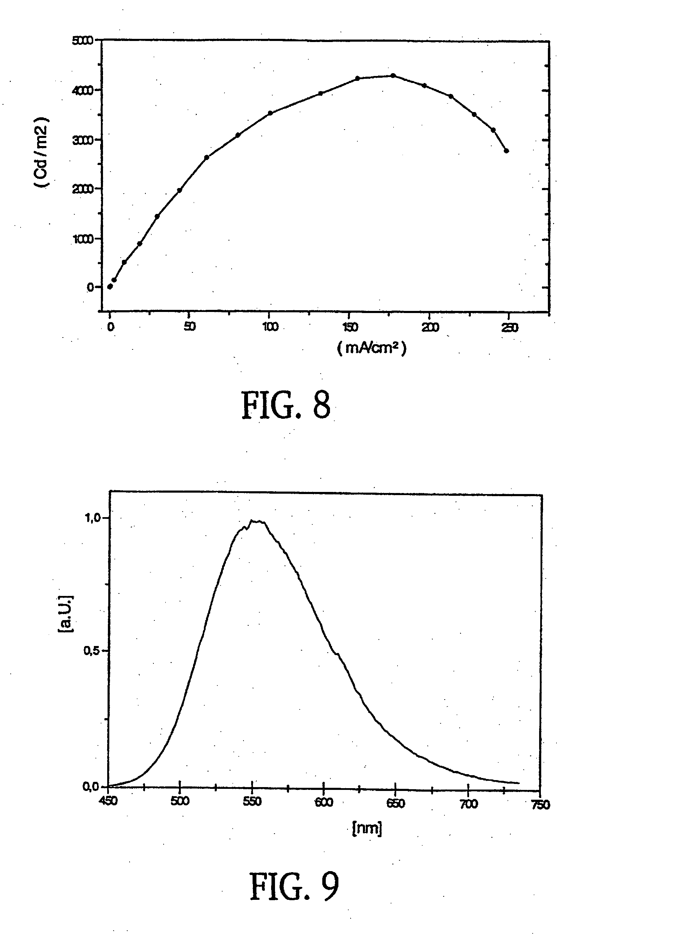

Bei Anlegen einer Spannung von 11 Volt wird eine Luminanz von 4200 cd/m² bei einem Strom von 175 mA/cm² beobachtet. Die Strom - Spannungskennlinie ist in Fig. 7, die Strom-Helligkeitskurve in Fig. 8 und das Emissionsspektrum in Fig. 9 abgebildet.

## Patentansprüche

1. Organisches elektrolumineszentes Bauelement mit einem transparenten Substrat, einer ersten transparenten Elektrode, einer organischen elektrolumineszenten Schicht, die eine Mischschicht aus einem Gemisch eines löchertransportierenden und eines elektronentransportierenden organischen Materials, das einen Exciplex bildet, ist und einer zweiten Elektrode, wobei zwischen der ersten Elektrode und der Mischschicht eine Schicht aus einem löchertransportierenden organischen Material und/oder zwischen der zweiten Elektrode und der Mischschicht eine Schicht aus einem elektronentransportierenden organischen Material angeordnet ist.

2. Organisches elektrolumineszentes Bauelement gemäß Anspruch 1,
**dadurch gekennzeichnet,**
**dass** das Gemisch, das einen Exciplex bildet, als löchertransportierendes Material eine oder mehrere Verbindungen aus der Gruppe
4,4',4"-tris(3-Methylphenylphenylamino)triphenylamin (MTDATA), N,N'-Diphenyl-N,N'-bis(3-methylphenyl)-1,1'-biphenyl-4,4'-diamin (TPD), N,N'-di(4-Methyl-phenyl)-N,N'-diphenyl-1,4-phenylendiamin und
1,1'-bis-(4'-bis-(4'-methyl-phenyl)-amino-phenyl)-cyclohexan (TAPC) und als elektronentransportierendes Material eine oder mehrere Verbindungen aus der Gruppe 2-(4-Biphenylyl)-5-phenyl-1,3,4-oxadiazol (PBD) und
5-(4-Biphenylyl)-3-(tert.-butylphenyl)-1,2,4-triazol (TAZ) enthält.

3. Organisches elektrolumineszentes Bauelement gemäß Anspruch 1,
**dadurch gekennzeichnet,**
**dass** das löchertransportierende Material
4,4',4"-tris(3-Methylphenylphenylamino)triphenylamin (MTDATA). und
das elektronentransportierende Material
5-(4-Biphenylyl)-3-(tert.-butylphenyl)-1,2,4-triazol (TAZ) ist.

## Claims

1. A organic electroluminescent component with a transparent substrate, a first transparent electrode, an organic electroluminescent layer which is a mixed layer comprising a mixture of a hole transporting and an electron transporting organic material which forms an exciplex, and a second electrode, wherein a layer of a hole-transporting organic material is arranged between the first electrode and the mixed layer and/or a layer of an electron-transporting organic material is arranged between the second electrode and the mixed layer.

2. An organic electroluminescent component as claimed in Claim 1, **characterized in that** the mixture forming an exciplex comprises as the hole transporting material one or several compounds from the group 4,4',4"-tris(3-methylphenylphenylamino)-triphenyl amine (MTDATA), N,N'-diphenyl-N,N'-bis(3-methylphenyl)-1,1'-biphenyl-4,4'-diamine (TPD), N,N'-di(4-methylphenyl)-N,N'-diphenyl-1,4-phenylenediamine, and 1,1'-bis-(4'-bis-(4'-methylphenyl)-aminophenyl)-cyclohexane (TAPC), and as the electron transporting material one or several compounds from the group of 2-(4-biphenylyl)-5-phenyl-1,3,4-oxadiazole (PBD) and 5-(4-biphenylyl)-3-(tert.-butylphenyl)-1,2,4-triazole (TAZ).

3. An organic electroluminescent component as claimed in Claim 1, **characterized in that** the hole transporting material is 4,4',4"-tris(3-methylphenylphenylamino)-triphenylamine (MTDATA) and the electron transporting material is 5-(4-biphenylyl)-3-(tert.-butylphenyl)-1,2,4-triazole (TAZ).

## Revendications

1. Elément électroluminescent organique avec un substrat transparent, une première électrode transparente, une couche électroluminescente organique qui comprend une couche mixte d'un mélange d'un matériau organique de transport de trous et d'un matériau organique de transportant d'électrons et forme un exciplex et avec une deuxième électrode, une couche d'un matériau organique de transport de trous étant disposés entre la première électrode et la couche mixte et/ou une couche d'un matériau organique de transport d'électrons étant disposée entre la deuxième électrode et la couche mixte.

2. Elément électroluminescent organique selon la revendication 1,
**caractérisé en ce**
**que** le mélange qui forme un exciplex contient comme matériau de transport de trous un ou plusieurs composés du groupe 4,4',4"-tris(3-méthylphénylphénylamino)-triphénylamine (MTDATA), N,N'-diphényl-N,N'-bis(3-méthylphényl)-1,1'-biphényl-4-4'-diamine (TPD), N,N'-di(4-méthylphényl)-N,N'-diphényl-1,4-phénylènediamine et 1,1'-bis-(4'-bis-(4'-méthylphényl)-aminophényl)-cyclohexane (TAPC) et comme matériau de transport d'électrons un ou plusieurs composés du groupe 2-(4-biphénylyl)-5-phényl-1,3,4-oxadiazole (PBD) et 5-(4-biphénylyl)-3-(tert.-butylphényl)-1,2,4-triazole (TAZ).

3. Elément électroluminescent organique selon la revendication 1,
**caractérisé en ce**
**que** le matériau de transport de trous est la 4,4',4"-tris(3-méthylphénylphénylamino)-triphénylamine (MTDATA) et le matériau de transport d'électrons le 5-(4-biphénylyl--3-(tert.-butylphényl)-1,2,4-triazole (TAZ).
